# EUROPÄISCHE PATENTSCHRIFT

(11) **EP 3 542 140 B1**
(45) Veröffentlichungstag und Bekanntmachung des Hinweises auf die Patenterteilung: **13.01.2021**
(21) Anmeldenummer: 17805104.1
(22) Anmeldetag: 17.11.2017
(51) Int. Cl.: G01M 3/16

(54) **FLÜSSIGKEITSSENSOR SOWIE VERFAHREN ZUM STEUERN EINER FUNKTION EINES FLÜSSIGKEITSSENSORS**
LIQUID SENSOR AND METHOD FOR CONTROLLING A LIQUID SENSOR FUNCTION
CAPTEUR DE LIQUIDE ET PROCÉDÉ POUR COMMANDER UNE FONCTION DE CAPTEUR DE LIQUIDE

(30) Priorität: 18.11.2016 DE 102016013754
(43) Veröffentlichungstag der Anmeldung: 25.09.2019
(73) Patentinhaber: Grohe AG, 58675 Hemer (DE)
(72) Erfinder: JUNG, Andreas, 58730 Fröndenberg (DE); SCHÖNBECK, Heiko, 58675 Hemer (DE)
(86) Internationale Anmeldenummer: PCT/EP2017/001352
(87) Internationale Veröffentlichungsnummer: WO 2018/091143

(56) Entgegenhaltungen:
- EP-A1- 3 021 267
- DE-A1-102004 033 804
- DE-A1-102015 103 617
- US-A- 3 942 167
- US-A1- 2008 150 705

## Beschreibung

Die vorliegende Erfindung betrifft einen Flüssigkeitssensor, mittels dem eine Leckage an Rohren oder Geräten detektierbar ist. Zudem betrifft die vorliegende Erfindung ein Verfahren zum Steuern einer Funktion eines solchen Flüssigkeitssensors.

Aus der EP 3 021 267 A1 ist ein Flüssigkeitssensor bekannt, der mittels einer Funkverbindung mit einem Empfänger verbindbar ist. Mittels der Funkverbindung ist eine Alarmmeldung bei einer detektierten Leckage über den Empfänger und einen Server an ein mobiles Gerät eines Benutzers meldbar. Zur Einrichtung der Funkverbindung muss der Flüssigkeitssensor an dem Empfänger angemeldet beziehungsweise mit dem Empfänger gekoppelt werden. Für eine vereinfachte Anmeldung wird häufig das sogenannte Wi-Fi Protected Setup (WPS) genutzt. Bei diesem muss zur Auslösung des Anmelde- beziehungsweise Kopplungsprozesses an dem Flüssigkeitssensor und dem Empfänger eine Taste gedrückt werden. Diese Taste muss an dem Flüssigkeitssensor wasser- und staubdicht ausgeführt sein, um eine Beschädigung des Flüssigkeitssensors durch Wasser oder Staub zu vermeiden. Das Ausstatten des Flüssigkeitssensors mit einer solchen Taste führt jedoch zu einem hohen Montage- und Kostenaufwand Ein weiteres für die Erfindung relevantes Dokument des Standes der Technik ist US 2008/150705 A1.

Aufgabe der Erfindung ist daher, die mit Bezug auf den Stand der Technik geschilderten Probleme zumindest teilweise zu lösen und insbesondere einen Flüssigkeitssensor anzugeben, bei dem eine Funktion des Flüssigkeitssensors ohne mechanische Taste steuerbar ist. Weiterhin soll auch ein Verfahren zum Steuern einer Funktion eines Flüssigkeitssensors angegeben werden, bei dem die Steuerung der Funktion ohne mechanische Taste erfolgt.

Diese Aufgaben werden gelöst mit einem Flüssigkeitssensor und einem Verfahren gemäß den Merkmalen der unabhängigen Patentansprüche. Weitere vorteilhafte Ausgestaltungen der Erfindung sind in den abhängig formulierten Patentansprüchen angegeben.

Der erfindungsgemäße Flüssigkeitssensor weist zumindest die folgenden Komponenten auf:
a) ein Gehäuse,
b) zumindest einen Sensor mit zumindest zwei metallischen Kontaktflächen zum Detektieren einer Flüssigkeit,
c) eine Verarbeitungseinheit zum Verarbeiten von Sensorsignalen des zumindest einen Sensors,
wobei durch ein Betätigen zumindest einer der metallischen Kontaktflächen eine Funktion des Flüssigkeitssensors steuerbar ist,
wobei die Funktion des Flüssigkeitssensors ein An- und Ausschalten des Flüssigkeitssensors oder ein Aktivieren oder Deaktivieren des zumindest einen Sensors ist.

Der vorgeschlagene Flüssigkeitssensor dient der Detektion von Leckagen an flüssigkeitsleitenden Leitungen oder Geräten, wie zum Beispiel Waschmaschinen oder Spülmaschinen beziehungsweise deren Versorgungsleitungen. Der Flüssigkeitssensor wird hierzu insbesondere im Bereich einer solchen flüssigkeitsleitenden Leitung oder eines solchen flüssigkeitsleitenden Geräts auf einem Boden positioniert. Der Flüssigkeitssensor weist ein Gehäuse auf, das zumindest einen Sensor mit zumindest zwei metallischen Kontaktflächen zum Detektieren einer Flüssigkeit, wie zum Beispiel Wasser, umfasst. Die zumindest zwei metallischen Kontaktflächen sind insbesondere nach Art von Kontaktstiften und/oder Messelektroden ausgebildet. Die zumindest zwei metallischen Kontaktflächen sind insbesondere nach Art von zumindest zwei Messelektroden ausgebildet. Die An- oder Abwesenheit der Flüssigkeit ist insbesondere über eine Änderung des Widerstands zwischen den zumindest zwei metallischen Kontaktflächen detektierbar. Die zumindest zwei metallischen Kontaktflächen erstrecken sich zudem insbesondere durch einen Gehäuseboden des Gehäuses und/oder in Richtung des Bodens, auf den der Flüssigkeitssensor abgestellt ist. An dem Gehäuseboden können Füße vorgesehen sein, die den Gehäuseboden von dem Boden beabstanden, sodass die Flüssigkeit die zumindest zwei metallischen Kontaktflächen zwischen dem Gehäuseboden und dem Boden kontaktieren kann.

Der Flüssigkeitssensor weist weiter eine Verarbeitungseinheit zum Verarbeiten von Sensorsignalen des zumindest einen Sensors auf. Bei den Sensorsignalen handelt es sich insbesondere um elektrische Signale beziehungsweise Daten des zumindest einen Sensors. Bei der Verarbeitungseinheit handelt es sich insbesondere um eine (digitale) Elektronikbaugruppe.

Die Steuerung einer Funktion des Flüssigkeitssensors, das heißt ein An- und Ausschalten des Flüssigkeitssensors, ein Aktivieren oder Deaktivieren eines Sensors des Flüssigkeitssensors oder ein Anmelden beziehungsweise Koppeln des Flüssigkeitssensors mit einer Empfangseinheit, erfolgt in vorteilhafter Weise durch ein Betätigen der zumindest einen metallischen Kontaktfläche. Die Betätigung der zumindest einen metallischen Kontaktfläche erfolgt insbesondere durch ein Berühren und/oder räumliches Verlagern gegenüber dem Gehäuse, der zumindest einen metallischen Kontaktfläche durch einen Benutzer des Flüssigkeitssensors. Der Flüssigkeitssensor benötigt daher keine separate (mechanische) Taste zur Steuerung der Funktion des Flüssigkeitssensors. Stattdessen wird die zumindest eine metallische Kontaktfläche als "Taste" verwendet.

Gemäß einem anderen Aspekt der Erfindung, weist der Flüssigkeitssensor eine Funkeinheit zum Senden der Sen sorsignale an eine Empfangseinheit auf, wobei die Funkeinheit durch ein Betätigen zumindest einer der metallischen Kontaktflächen mit der Empfangseinheit koppelbar ist. Bei der Funkeinheit handelt es sich insbesondere um ein Bluetooth- oder WLAN-Modul, mittels dem die Sensorsignale des zumindest einen Sensors an die Empfangseinheit sendbar sind. Bei der Empfangseinheit kann es sich beispielsweise um einen Access-Point, einen Hub, einen Router oder eine andere Funkeinheit handeln. Die Funkeinheit ist durch ein Betätigen beziehungsweise Berühren zumindest einer der zumindest zwei metallischen Kontaktflächen mit der Empfangseinheit koppelbar. Die Kopplung erfolgt insbesondere nach dem Wi-Fi Protected Setup (WPS) Verfahren, mit dem ein drahtloses lokales Netzwerk zwischen dem Flüssigkeitssensor und der Empfangseinheit einrichtbar ist.

Weiterhin ist es vorteilhaft, wenn die Funkeinheit zumindest eine Hochfrequenzeinheit umfasst. Hierdurch kann die Funkeinheit insbesondere in einem Funknetzwerk nach den Industriestandards der IEEE-802.11-Familie oder IEEE 802.15.x (IEEE 802.15.1: Bluetooth, IEEE 802.15.2: ZigBee, usw.) betrieben werden.

Zudem ist es vorteilhaft, wenn die Verarbeitungseinheit zur Identifizierung einer Betätigung der zumindest einen metallischen Kontaktfläche eingerichtet ist.

Nach der Aktivierung einer Energiequelle des Flüssigkeitssensors, beispielsweise nach dem Einlegen einer oder mehrerer Batterien, überwacht der Sensor innerhalb einer bestimmten Zeitspanne, z. B. zwei Minuten, ein Kurzschließen der metallischen Kontaktflächen. Bei Auftreten eines Kurzschlusses innerhalb dieser Zeitspanne wird der Kurzschluss nicht als Leckage oder Überflutung gewertet, sondern genutzt, um eine Funktion des Flüssigkeitssensors zu steuern, zum Beispiel das WLAN-Modul einzuschalten und den Verbindungsprozess mit dem Empfänger zu initiieren. Weiterhin kann durch eine Betätigung der zumindest einen metallischen Kontaktfläche auch die Funkeinheit beziehungsweise das WLAN-Modul im sogenannten gemischten Access Point / Station Mode AP/STA Mode in Betrieb genommen werden. Nun kann ein Benutzer sich mittels eines mobilen Geräts, wie zum Beispiel mit einem Smartphone, mit einem Access Point der Einrichtung (Appliance) verbinden. Parallel dazu kann ein per Software-Anwendung, wie zum Beispiel per Mobile App, konfiguriertes WLAN-Modul parallel zum selbst initiierten Access Point Kontakt zu einem anderen Access Point (WLAN-Router) aufnehmen und so die Verbindung zum Cloud Server testen und das Ergebnis direkt zurück auf das mobile Gerät melden. Nachdem die Konfiguration abgeschlossen ist, werden der Access Point und Station Mode durch die Appliance geschlossen. Bei einer Leckage oder einem Wasser-Alarm o. ä. kann dann die Funkeinheit beziehungsweise das WLAN-Modul ohne weitere Konfiguration in Betrieb genommen werden. Diese arbeitet dabei im zuvor konfiguriertem Station Mode und nimmt Kontakt zu dem WLAN-Router und im weiteren zum Cloud-Server auf.

Weiterhin ist es vorteilhaft, wenn zumindest ein Analogeingang oder ein Digitaleingang der Verarbeitungseinheit zur Identifikation einer Betätigung der zumindest einen metallischen Kontaktfläche verwendet wird. Hierbei kann insbesondere eine Schwellwertschalte genutzt werden. Hierzu wird beispielsweise ein Kondensator über eine Ladeschaltung auf ein bestimmtes Potential aufgeladen. Über eine Transistorbeschaltung wird dabei ein Ausgangssignal auf ein bestimmtes Potential gehoben. An dem Kondensator ist in diesem Falle eine der beiden metallischen Kontaktflächen angeschlossen. Dessen elektrisches Potential beträgt nach einer bestimmten Zeitdauer die des Kondensators. Wird nun eine niederimpedante Verbindung zwischen den beiden Kontaktflächen hergestellt, z. B. durch eine leitfähige Flüssigkeit, sinkt das Potential am Kondensator ab. Je leitfähiger die Flüssigkeit zwischen den metallischen Kontaktflächen beziehungsweise Kontaktstiften ist, desto schneller sinkt das elektrische Potential am Kondensator ab. Eine Nachspeisung des Kondensators durch die Ladeschaltung ist langsamer. Unterschreitet das Potential am Kondensator einen bestimmten Wert, ändert sich das Potential am Transistorausgang. Diese Änderung wird durch einen Interrupt-auslösenden Eingang des Mikrokontrollers detektiert. Der Interrupt bewirkt das Auslösen einer Alarmmeldung in die Cloud.

Des Weiteren ist es vorteilhaft, wenn die Verarbeitungseinheit zumindest einen Mikrokontroller umfasst. Der Mikrokontroller ist insbesondere nach Art einer CPU ausgebildet.

Ebenfalls vorteilhaft ist es, wenn die zumindest zwei metallischen Kontaktflächen relativ zu dem Gehäuse nicht bewegbar sind. Mit anderen Worten sind die zumindest zwei metallischen Kontaktflächen starr ausgebildet. Hierdurch ist das Gehäuse besonders einfach gegen ein Eindringen einer Flüssigkeit oder von Staub schützbar.

Einem weiteren Aspekt der Erfindung folgend wird auch ein Verfahren zum Steuern einer Funktion eines Flüssigkeitssensors angegeben, wobei die Steuerung der Funktion durch eine Betätigung zumindest einer von zumindest zwei metallischen Kontaktflächen eines Sensors zum Detektieren einer Flüssigkeit erfolgt. Das Verfahren dient insbesondere dem Steuern einer Funktion eines erfindungsgemäßen Flüssigkeitssensors. Für weitere Einzelheiten wird daher auf die Beschreibung des erfindungsgemäßen Flüssigkeitssensors verwiesen.

Die Erfindung sowie das technische Umfeld werden nachfolgend anhand der Figur näher erläutert. Es ist darauf hinzuweisen, dass die Figur eine besonders bevorzugte Ausführungsvariante der Erfindung zeigt, diese jedoch nicht darauf beschränkt ist. Es zeigt beispielhaft und schematisch:

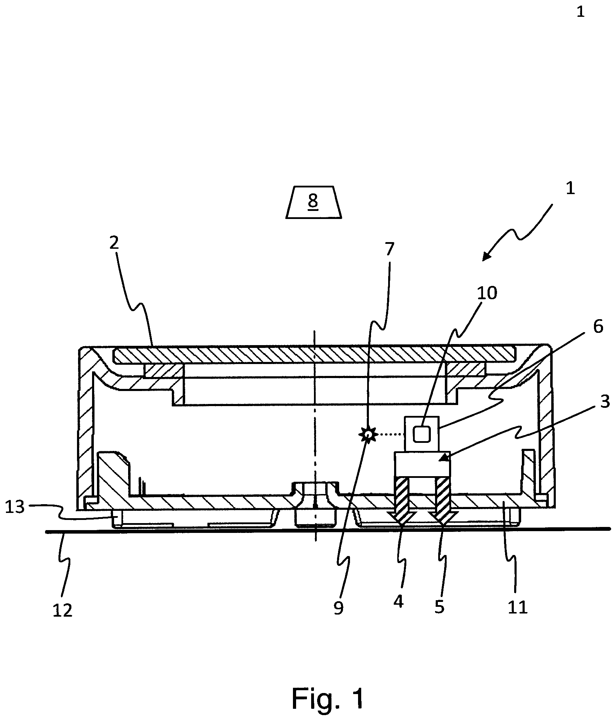

- Fig. 1:: einen Flüssigkeitssensor im Längsschnitt.

Die Fig. 1 zeigt einen Flüssigkeitssensor 1 im Längsschnitt, der in der Fig. 1 auf einem Boden 12 in der Nähe einer hier nicht gezeigten Flüssigkeitsleitung angeordnet ist. Der Flüssigkeitssensor 1 weist ein Gehäuse 2 mit einem Sensor 3 auf. Der Sensor 3 umfasst eine erste metallische Kontaktfläche 4 und eine zweite metallische Kontaktfläche 5, die nach Art von Messelektroden ausgebildet sind und sich durch einen Gehäuseboden 11 des Gehäuses 2 in Richtung des Bodens 12 erstrecken, sodass eine Flüssigkeit bei einer Leckage der Wasserleitung die erste metallische Kontaktfläche 4 und die zweite metallische Kontaktfläche 5 zwischen dem Gehäuseboden 11 und dem Boden 12 kontaktieren kann. Der Gehäuseboden weist zudem Füße 13 auf, die den Gehäuseboden 11 von dem Boden 12 beabstanden. Die erste metallische Kontaktfläche 4 und die zweite metallische Kontaktfläche 5 sind relativ zu dem Gehäuse starr ausgebildet. Weiterhin sind die erste metallische Kontaktfläche 4 und die zweite metallische Kontaktfläche 5 zur Steuerung einer Funktion des Flüssigkeitssensors 1 außerhalb des Gehäuses 2 durch einen Benutzer betätigbar beziehungsweise berührbar, wenn der Flüssigkeitssensor 1 nicht auf dem Boden 12 abgestellt ist. Der Sensor 3 ist mit einer Verarbeitungseinheit 6 zum Verarbeiten von Sensorsignalen des Sensors 3 und zur Identifizierung einer Betätigung der ersten metallischen Kontaktfläche 4 und zweiten metallische Kontaktfläche 5 verbunden. Hierzu weist die Verarbeitungseinheit 6 einen Mikrocontroller 10 auf. Die Verarbeitungseinheit 6 ist wiederum datenleitend mit einer Funkeinheit 7 verbunden, die eine Hochfrequenzeinheit 9 umfasst. Mit der Funkeinheit 7 sind die Sensorsignale des Sensors 3 über ein drahtloses Netzwerk an eine Empfangseinheit 8 sendbar. Bei einer Betätigung der ersten metallischen Kontaktfläche 4 und/oder der zweiten metallischen Kontaktfläche 5 durch einen Benutzer ist durch die Verarbeitungseinheit 6 die Funkeinheit 7 mit der Empfangseinheit 8 nach dem WPS-Verfahren koppelbar.

Die vorliegende Erfindung zeichnet sich insbesondere dadurch aus, dass eine Funktion des Flüssigkeitssensors 1 ohne eine separate (mechanische) Taste steuerbar ist.

### Bezugszeichenliste

- 1: Flüssigkeitssensor
- 2: Gehäuse
- 3: Sensor
- 4: erste metallische Kontaktfläche
- 5: zweite metallische Kontaktfläche
- 6: Verarbeitungseinheit
- 7: Funkeinheit
- 8: Empfangseinheit
- 9: Hochfrequenzeinheit
- 10: Mikrocontroller
- 11: Gehäuseboden
- 12: Boden
- 13: Fuß

## Patentansprüche

1. Flüssigkeitssensor (1), aufweisend:
a) ein Gehäuse (2),
b) zumindest ein Sensor (3) mit zumindest zwei metallischen Kontaktflächen (4, 5) zum Detektieren einer Flüssigkeit,
c) eine Verarbeitungseinheit (6) zum Verarbeiten von Sensorsignalen des zumindest einen Sensors (3),
**dadurch gekennzeichnet, dass** durch ein Betätigen zumindest einer der metallischen Kontaktflächen (4, 5) eine Funktion des Flüssigkeitssensors (1) steuerbar ist, wobei die Funktion des Flüssigkeitssensors (1) ein An- und Ausschalten des Flüssigkeitssensors (1) oder ein Aktivieren oder Deaktivieren des zumindest einen Sensors (3) ist.

2. Flüssigkeitssensor (1) und Empfangseinheit (8), wobei der Flüssigkeitssensor (1) aufweist
a) ein Gehäuse (2),
b) zumindest ein Sensor (3) mit zumindest zwei metallischen Kontaktflächen (4, 5) zum Detektieren einer Flüssigkeit,
c) eine Verarbeitungseinheit (6) zum Verarbeiten von Sensorsignalen des zumindest einen Sensors (3),
d) eine Funkeinheit (7) zum Senden der Sensorsignale an die Empfangseinheit (8), **dadurch gekennzeichnet, dass** durch ein Betätigen zumindest einer der metallischen Kontaktflächen (4, 5) eine Funktion des Flüssigkeitssensors (1) steuerbar ist, wobei die Funktion des Flüssigkeitssensors (1) ein Anmelden bzw. Koppeln des Flüssigkeitssensors (1) mit der Empfangseinheit (8) ist.

3. Flüssigkeitssensor (1) nach Patentanspruch 1, aufweisend eine Funkeinheit (7) zum Senden der Sensorsignale an eine Empfangseinheit (8), wobei die Funkeinheit (7) durch ein Betätigen zumindest einer der metallischen Kontaktflächen (4, 5) mit der Empfangseinheit (8) koppelbar ist.

4. Flüssigkeitssensor (1) nach Patentanspruch 2 oder 3, wobei die Funkeinheit (7) zumindest eine Hochfrequenzeinheit (9) umfasst.

5. Flüssigkeitssensor (1) nach einem der vorhergehenden Patentansprüche, wobei die Verarbeitungseinheit (6) zur Identifizierung einer Betätigung zumindest einer der metallischen Kontaktflächen (4, 5) eingerichtet ist.

6. Flüssigkeitssensor (1) nach einem der vorhergehenden Patentansprüche, wobei zumindest ein Analogeingang oder ein Digitaleingang der Verarbeitungseinheit (6) zur Identifizierung einer Betätigung zumindest einer der metallischen Kontaktflächen (4, 5) verwendet wird.

7. Flüssigkeitssensor (1) nach einem der vorhergehenden Patentansprüche, wobei die Verarbeitungseinheit (6) zumindest einen Mikrocontroller (10) umfasst.

8. Flüssigkeitssensor (1) nach einem der vorhergehenden Patentansprüche, wobei die zumindest zwei metallischen Kontaktflächen (4, 5) relativ zu dem Gehäuse (2) nicht bewegbar sind.

9. Verfahren zum Steuern einer Funktion eines Flüssigkeitssensors (1) nach Anspruch 1 oder 2, wobei die Steuerung der Funktion durch eine Betätigung zumindest einer von zumindest zwei metallischen Kontaktflächen (4, 5) eines Sensors (3) zum Detektieren einer Flüssigkeit erfolgt, wobei die Funktion des Flüssigkeitssensors (1) ein An- und Ausschalten des Flüssigkeitssensors (1) oder ein Aktivieren oder Deaktivieren des Sensors (3) oder ein Anmelden bzw. Koppeln des Flüssigkeitssensors (1) mit einer Empfangseinheit (8) ist.

## Claims

1. A liquid sensor (1) having:
a) a housing (2),
b) at least one sensor (3) with at least two metal contact surfaces (4, 5) for detecting a liquid,
c) a processing unit (6) for processing sensor signals of the at least one sensor (3),
**characterized in that** a function of the liquid sensor (1) can be controlled by an actuation of at least one of the metal contact surfaces (4, 5), wherein the function of the liquid sensor (1) is an on- and off-switching of the liquid sensor (1) or an activation or deactivation of the at least one sensor (3).

2. A liquid sensor (1) and receiver unit (8), wherein the liquid sensor (1) has
a) a housing (2),
b) at least one sensor (3) with at least two metal contact surfaces (4, 5) for detecting a liquid,
c) a processing unit (6) for processing sensor signals of the at least one sensor (3),
d) a radio unit (7) for transmitting the sensor signals to the receiver unit (8),
**characterized in that** a function of the liquid sensor (1) can be controlled by an actuation of at least one of the metal contact surfaces (4, 5), wherein the function of the liquid sensor (1) is a log-in or coupling of the liquid sensor (1) to the receiver unit (8) .

3. The liquid sensor (1) according to Claim 1, having a radio unit (7) for transmitting the sensor signals to a receiver unit (8), wherein the radio unit (7) can be coupled to the receiver unit (8) by an actuation of at least one of the metal contact surfaces (4, 5).

4. The liquid sensor (1) according to Claim 2 or 3, wherein the radio unit (7) comprises at least one high frequency unit (9).

5. The liquid sensor (1) according to any one of the preceding claims, wherein the processing unit (6) is designed for identifying an actuation of at least one of the metal contact surfaces (4, 5).

6. The liquid sensor (1) according to any one of the preceding claims, wherein at least an analog input or a digital input of the processing unit (6) is used for identifying an actuation of at least one of the metal contact surfaces (4, 5).

7. The liquid sensor (1) according to any one of the preceding claims, wherein the processing unit (6) comprises at least one micro-controller (10).

8. The liquid sensor (1) according to any one of the preceding claims, wherein the at least two metal contact surfaces (4, 5) are non-movable relative to the housing (2) .

9. A method for controlling a function of a liquid sensor (1) according to Claim 1 or 2, wherein the controlling of the function is effected by an actuation of at least one of at least two metal contact surfaces (4, 5) of a sensor (3) for detecting a liquid, wherein the function of the liquid sensor (1) is an on- and off-switching of the liquid sensor (1) or an activation or deactivation of the sensor (3) or a log-in or coupling of the liquid sensor (1) to a receiver unit (8).

## Revendications

1. Capteur de liquide (1), comportant :
a) un boîtier (2),
b) au moins un capteur (3) pourvu d'au moins deux surfaces de contact (4, 5) métalliques, destiné à détecter un liquide,
c) une unité de traitement (6), destinée à traiter des signaux de capteur de l'au moins un capteur (3),
**caractérisé en ce que**
par un actionnement d'au moins l'une des surfaces de contact (4, 5) métalliques, une fonction du capteur de liquide (1) est susceptible d'être commandée, la fonction du capteur de liquide (1) étant une mise en marche et une mise à l'arrêt du capteur de liquide (1) ou une activation ou une désactivation de l'au moins un capteur (3).

2. Capteur de liquide (1) et unité réceptrice (8), le capteur de liquide (1) comportant
a) un boîtier (2),
b) au moins un capteur (3), pourvu d'au moins deux surfaces de contact (4, 5) métalliques, destiné à détecter un liquide,
c) une unité de traitement (6), destinée à traiter des signaux de capteur de l'au moins un capteur (3),
d) une unité radio (7), destinée à envoyer des signaux de capteur à l'unité réceptrice (8),
**caractérisé en ce que**
par un actionnement d'au moins l'une des surfaces de contact (4, 5) métalliques, une fonction du capteur de liquide (1) est susceptible d'être commandée, la fonction du capteur de liquide (1) étant un enregistrement ou une connexion du capteur de liquide (1) avec l'unité réceptrice (8).

3. Capteur de liquide (1) selon la revendication 1, comportant une unité radio (7), destinée à envoyer les signaux du capteur à une unité réceptrice (8), l'unité radio (7) étant susceptible d'être connectée avec l'unité réceptrice (8) par un actionnement d'au moins l'une des surfaces de contact (4, 5) métalliques.

4. Capteur de liquide (1) selon la revendication 2 ou 3, l'unité radio (7) comprenant au moins une unité haute fréquence (9).

5. Capteur de liquide (1) selon l'une quelconque des revendications précédentes, l'unité de traitement (6) étant aménagée pour identifier un actionnement d'au moins l'une des surfaces de contact (4, 5) métalliques.

6. Capteur de liquide (1) selon l'une quelconque des revendications précédentes, au moins une entrée analogique ou une entrée numérique de l'unité de traitement (6) étant utilisée pour identifier un actionnement de l'une des surfaces de contact (4, 5) métalliques.

7. Capteur de liquide (1) selon l'une quelconque des revendications précédentes, l'unité de traitement (6) comprenant au moins un microcontrôleur (10).

8. Capteur de liquide (1) selon l'une quelconque des revendications précédentes, les au moins deux surfaces de contact (4, 5) métalliques n'étant pas mobiles par rapport au boîtier (2).

9. Procédé, destiné à commander une fonction d'un capteur de liquide (1) selon la revendication 1 ou 2, la commande de la fonction s'effectuant par un actionnement d'au moins l'une parmi au moins deux surfaces de contact (4, 5) métalliques d'un capteur (3) pour la détection d'un liquide, la fonction du capteur de liquide (1) étant une mise en marche et une mise à l'arrêt du capteur de liquide (1) ou une activation ou une désactivation de l'au moins un capteur (3) ou un enregistrement ou une connexion du capteur de liquide (1) avec l'unité réceptrice (8).
